Europäisches Patentamt

European Patent Office

Office européen des brevets

(11) Publication number: **0 269 860**
**A2**

## (12) EUROPEAN PATENT APPLICATION

(21) Application number: 87115831.7

(51) Int. Cl.⁴ **H03M 1/82**

(22) Date of filing: 28.10.87

(30) Priority: 31.10.86 US 925592

(43) Date of publication of application:
08.06.88 Bulletin 88/23

(84) Designated Contracting States:
CH DE FR GB IT LI

(71) Applicant: SPACELABS, INC.
4200 150th Avenue NE
Redmond Washington 98073-9713(US)

(72) Inventor: Logan, Charles H.
19527 - 172nd Avenue
Woodinville Washington 98072(US)

(74) Representative: Patentanwälte Grünecker,
Kinkeldey, Stockmair & Partner
Maximilianstrasse 58
D-8000 München 22(DE)

(54) **Digital to analog converter apparatus.**

(57) A method and apparatus for generating time varying analog output signals in response to digitial timing and control signals is disclosed. Periodic voltage ramp signals are generated in response to a digital timing signal and time varying analog output signals are generated from the ramp signals in response to digital control signals.

FIG. 1

## DIGITAL TO ANALOG CONVERTER APPARATUS

### Background of the Invention

This invention relates to a digital to analog output device which allows analog voltage output signals to be generated from digital timing and control signals. Often, analog signals are digitized and stored in a microprocessor for further processing and analysis. Sometimes it is desirable to recover the analog form of the signals from the digital representation stored in the microprocessor or to generate analog signals from digital signals. It is highly desirable to be able to provide the analog output signals using the inherent digital output speed of the processor itself.

### Summary of the Invention

According to the present invention an apparatus for generating time-varying analog output signals from digital timing and control signals is provided. Means are provided for generating periodic voltage ramp signals from digital timing signals. The duration and pulse repetition rate of the timing signals helps to control the characteristics of the ramp signals. Means coupled to said ramp signal generating means generate at least one time varying analog output signal from said periodically occurring ramp signals in response to digital control signals. In the preferred embodiment, a plurality of time varying analog output signals can be generated simultaneously.

In accordance with the invention a current source changes a capacitor to generate a linear voltage ramp signal while an electronic switch coupled between the capacitor and ground discharges the capacitor and diverts the current flow to ground in response to a digitial timing signal to restart the ramp.

In the preferred embodiment, a plurality of sample and hold circuits coupled in parallel to the ramp signal generating means in response to the digital control signals provide sample voltage(s) to a plurality of amplifier and filter circuits which in turn provide a plurality of analog voltage output signals simultaneously.

### Brief Description of the Drawings

Fig. 1 is a schematic of the preferred embodiment circuit of the present invention.

FIG. 1A is a block diagram of the processor which provides the digital signals to the circuit of FIG. 1.

FIG. 2 is a timing diagram showing the relationship between the voltage ramp signals and the timing signals.

### Detailed Description of the Drawings

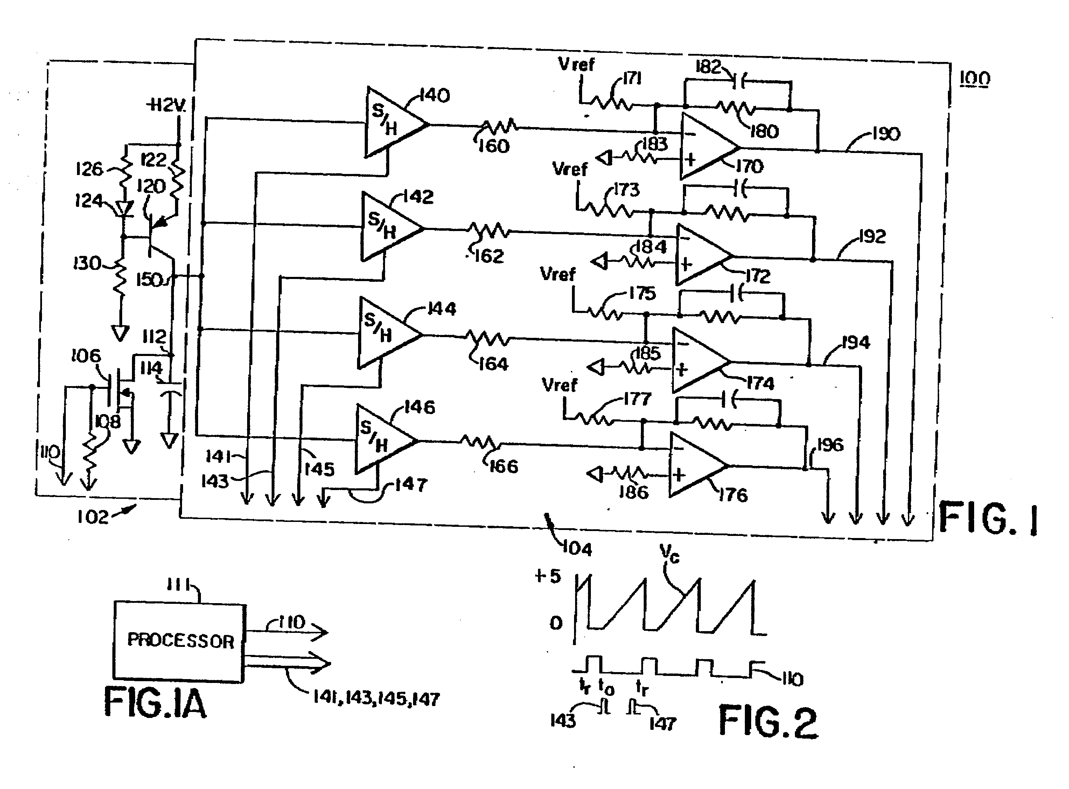

Referring now to FIG. 1, the preferred embodiment circuit designated generally 10 for reproducing analog output signals from digital timing signals is provided. This current 100 comprises a voltage ramp generation circuit designated generally 102 and a sample and hold output circuit designated generally 104.

The ramp generation circuit 102 comprises a field effect transistor (FET) 106 whose base is coupled to ground through a resistor 108 and further coupled to a timing control line 110 on which an Intel 8096 microprocessor (111 in FIG. 1A) provides a high speed timing signal. The source of the FET is coupled to ground while the drain is coupled via junction 112 to one side of capacitor 114. The other side of capacitor 114 is coupled to ground.

Junction 112 is further coupled to the collector of transistor 120 whose emitter is coupled through resistor 122 to a plus 12 volt power source. The base of the transistor 120 is coupled through diode 124 in series with resistor 126 to the same plus 12 volt power supply. The base is also coupled through resistor 130 to ground.

The sampling and output circuit 104 comprises four sample and hold devices even numbers 140 through 146 which, in the preferred embodiment, are National Semiconductor LM398 devices. Separate high speed control lines odd numbers 141 through 147 from the processor are shown coupled to each of the sample and hold devices even numbers 140 through 146, respectively. The ramp circuit 102 is coupled to the input of each of the sample and hold circuits even numbers 140 through 146 through the junction 150 between the collector of transistor 120 and the junction 112.

The output of each sample and hold circuit even numbers 140 through 146 is coupled through resistors even numbers 160 through 166, respectively, to the negative input terminals of operational amplifiers even numbers 170 through 176, respectively. The operational amplifiers are in the preferred embodiment National Semiconductor model numbers LM324. The output of each of the operational amplifiers are fed back through identical filter circuits each comprising a resistor 180 in parallel with a capacitor 182. The filter circuit is identical for each operational amplifier and provides filtering of the sample and hold output which typically contains some noise or spurious signal. The filter circuit also provides gain scaling. The negative input terminal of each of the operational amplifiers is further coupled through resistors odd numbers 171 through 177, respectively, to a reference voltage to provide voltage offset. The positive input terminal of each of the operational amplifiers is coupled through resistors 183 through 186 to ground to provide bias compensation. The output of each of the operational amplifiers provides a separate analog voltage output line even numbers 190 through 196.

Referring now to FIGS. 1 and 2 when the high speed timing signal 110 is low the transistor 120 linearly charges the capacitor 114 causing the voltage across the capacitor as measured at the junction 150 to increase linearly as in FIG. 2 where $V_C$ linearly increases from 0 to nominally 5 volts while signal 110 is low. When signal 110 goes high at $t_r$ the field effect transistor 106 turns on suddenly discharging the capacitor 114. Then when the signal 110 goes low again the voltage at junction 150 again begins to increase linearly.

When it is desired to sample the linearly varying voltage ramp signal 110, a high signal is provided on one of the high speed output control lines odd numbers 141 through 147. When a control line is high, the sample and hold device coupled thereto will sample the ramp signal, and when the control line goes low, the sample and hold device will hold the sampled voltage. Hence, by providing a pulsed high speed control line signal at an appropriate time during the period when the ramp voltage signal $V_C$ is linearly increasing a selected voltage level can be sampled and held by the sample and hold device.

The output of each sample and hold device even numbers 140 through 146 is coupled to its associated operational amplifier (even numbers 170 through 176) and filter circuit comprised of resistor 180 and parallel capacitor 182 which together serve to amplify and filter the sample and hold output signal and provide an analog output signal in an associated analog output line even numbers 190 through 196. The chosen voltage level will remain on the analog output signal line until the associated control line again is pulsed high.

For example, if just after the time $t_o$ when the voltage ramp signal just begins the control line 143 is pulsed high, sample and hold device 142 will sample the voltage ramp $V_C$ at that time and hold the voltage value at the time the control line 143 goes low again. The voltage level might be, for example, 1.0 volts which will be processed by the operational amplifier 172 and associated filter circuit to provide an analog voltage level output signal on line 192.

At a later time during the same ramp cycle for example, at the point where $V_C$ becomes 3 volts, if the control line 147 is pulsed high, the sample and hold device 146 will provide a three volt signal to the amplifer 176 which will provide an analog voltage output signal on line 196. With the embodiment shown in FIG. 1 as many as four different analog voltage levels can be provided at one time, although more than four voltage levels could be provided by adding more sample and hold circuits and associated control lines and output amplifier circuits.

A time varying analog voltage signal can be generated by sampling the periodically occurring voltage ramps at different voltage levels. If control line 143 is pulsed high at a first ramp signal at 1.0 volts and then on a subsequent ramp it is pulsed at 3.0 volts, the output signal on line 192 will vary from 1 to 3 volts. If the ramp voltages are created at a high enough rate the output or lines 190 through 196 will appear as time varying analog output signal.

## Claims

1. An apparatus for providing analog voltage output signals from digital timing and control signals comprising:
means for generating periodic voltage ramp signals in response to digital timing signals; and
means for generating at least one time varying analog output signal from said periodically occurring ramp signals in response to digital control signals.

2. The apparatus of Claim 1 wherein said ramp signal generating means comprises:
a capacitor coupled to said analog output signal generating means;
means coupled to said capacitor for charging said capacitor; and
means coupled to said capacitor for discharging said capacitor in response to said digital timing signal.

3. The apparatus of Claim 2 wherein said capacitor charging means comprises a current source coupled to said capacitor and said discharging means comprises an electronic switch means coupled between the junction formed by coupling said current source and said capacitor and ground.

4. The apparatus of Glaim 3 wherein said current source comprises a transistor coupled between a voltage source and said junction and said electronic switch comprises a field effect transistor whose base is coupled to said digital timing signal.

5. The apparatus of Claim 1 wherein said analog output signal generating means comprises means for generating a plurality of time varying output signals simultaneously.

6. The apparatus of Claim 5 wherein said analog output signal generating means comprises a plurality of sample and hold means coupled in parallel to said ramp signal generating means.

7. The apparatus of Claim 6 wherein the output of each of said sample and hold means is coupled to an operational amplifier circuit whose output comprises a time varying analog output signal.

8. A method of generating time varying analog output signals from digital timing and control signals comprising the steps of:
generating periodic voltage ramp signals in response to digital timing signals; and
generating at least one time varying analog output signal from said periodically occurring ramp signals in response to digital control signals.

9. The method of Claim 8 wherein said step of generating periodic ramp signals comprises the steps of:
charging a capacitor from a current source; and
discharging said capacitor with an electronic switch in response to said digital timing signals.

10. The method of claim 8 wherein said analog signal generating step comprises:
sampling and holding said ramp signals in response to said digital control signals.

FIG. 1

FIG.1A

PROCESSOR

141,143,145,147

FIG.2

0 269 860